# EUROPEAN PATENT APPLICATION

(11) **EP 4 138 117 A1**
(43) Date of publication of application: **22.02.2023**
(21) Application number: 22182715.7
(22) Date of filing: 04.07.2022
(51) Int. Cl.: H01L 21/336, H01L 29/775, H01L 29/06, H01L 29/08, H01L 29/423, H01L 21/8234, H01L 21/8238, H01L 23/528, H01L 23/535, H01L 29/78, H01L 29/16, B82Y 10/00

(54) **MULTI-LAYERED MULTI-FUNCTION SPACER STACK**

(30) Priority: 16.08.2021 US 202117403247
(71) Applicant: Intel Corporation, Santa Clara, CA 95054 (US)
(72) Inventor: Wei, Andy, Yamhill, OR 97148 (US); Bouche, Guillaume, Portland, OR 97211 (US)
(74) Representative: Goddar, Heinz J.

(57) **Abstract**

Techniques are provided to form semiconductor devices having a multi-layer spacer structure. In an example, a semiconductor device includes a semiconductor region extending between a source region and a drain region, and a gate layer extending over the semiconductor region. A spacer structure made up of one or more dielectric layers is present along a sidewall of the gate structure and along a sidewall of the source region or the drain region. The spacer structure has three different portions: a first portion along the sidewall of the gate, a second portion along the sidewall of the source or drain region, and a third portion that connects between the first two portions. The third portion of the spacer structure has a multi-layer configuration while the first and second portions have a fewer number of material layers.

## Description

### FIELD OF THE DISCLOSURE

The present disclosure relates to integrated circuits, and more particularly, to spacer structures.

### BACKGROUND

As integrated circuits continue to scale downward in size, a number of challenges arise. For instance, reducing the size of memory and logic cells is becoming increasingly more difficult. Certain aspects of lithography technology can impose physical limits on the size of a transistor's gate length or on the size of the source and drain regions on the ends of the transistor's gated channel region. Spacer structures have been used during semiconductor fabrication processes to laterally define certain critical dimensions but controlling the thickness of such spacers with a very fine resolution is difficult. Accordingly, there remain a number of non-trivial challenges with respect to semiconductor spacer formation.

### BRIEF DESCRIPTION OF THE DRAWINGS

Figure 1 is an isometric view of an integrated circuit structure that includes a multi-layered spacer structure, in accordance with an embodiment of the present disclosure.
Figures 2A and 2B are cross-sectional views that illustrate one stage in an example process for forming an integrated circuit configured with a multi-layered spacer structure, in accordance with an embodiment of the present disclosure.
Figures 3A and 3B are cross-sectional views that illustrate another stage in the example process for forming an integrated circuit configured with a multi-layered spacer structure, in accordance with an embodiment of the present disclosure.
Figures 4A and 4B are cross-sectional views that illustrate another stage in the example process for forming an integrated circuit configured with a multi-layered spacer structure, in accordance with an embodiment of the present disclosure.
Figures 5A and 5B are cross-sectional views that illustrate another stage in the example process for forming an integrated circuit configured with a multi-layered spacer structure, in accordance with an embodiment of the present disclosure.
Figures 6A and 6B are cross-sectional views that illustrate another stage in the example process for forming an integrated circuit configured with a multi-layered spacer structure, in accordance with an embodiment of the present disclosure.
Figures 7A and 7B are cross-sectional views that illustrate another stage in the example process for forming an integrated circuit configured with a multi-layered spacer structure, in accordance with an embodiment of the present disclosure.
Figures 8A and 8B are cross-sectional views that illustrate another stage in the example process for forming an integrated circuit configured with a multi-layered spacer structure, in accordance with an embodiment of the present disclosure.
Figures 9A and 9B are cross-sectional views that illustrate another stage in the example process for forming an integrated circuit configured with a multi-layered spacer structure, in accordance with an embodiment of the present disclosure.
Figures 10A and 10B are cross-sectional views that illustrate another stage in the example process for forming an integrated circuit configured with a multi-layered spacer structure, in accordance with an embodiment of the present disclosure.
Figures 11A and 11B are cross-sectional views that illustrate another stage in the example process for forming an integrated circuit configured with a multi-layered spacer structure, in accordance with an embodiment of the present disclosure.
Figures 12A and 12B are cross-sectional views that illustrate another stage in the example process for forming an integrated circuit configured with a multi-layered spacer structure, in accordance with an embodiment of the present disclosure.
Figure 13 illustrates a cross-section view of a chip package containing one or more semiconductor dies, in accordance with some embodiments of the present disclosure.
Figure 14 is a flowchart of a fabrication process for semiconductor device having a multi-layer spacer structure, in accordance with an embodiment of the present disclosure.
Figure 15 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles, and some features may have surface topology or otherwise be non-smooth, given real world limitations of the processing equipment and techniques used.

### DETAILED DESCRIPTION

Techniques are provided herein to form semiconductor devices having a multi-layer spacer structure. The techniques can be used in any number of integrated circuit applications and are particularly useful with respect to logic and memory cells, such as those cells that use finFETs or gate-all-around transistors. In an example, a semiconductor device includes a semiconductor region extending between a source region and a drain region, and a gate layer extending over the semiconductor region. A spacer structure made up of one or more dielectric layers is present along a sidewall of the gate structure and along a sidewall of the source region or the drain region. The spacer structure may be defined as having three different portions: a first portion along the sidewall of the gate, a second portion along the sidewall of the source or drain region, and a third portion that connects between the first two portions. According to some embodiments, the third portion of the spacer structure has a multi-layer configuration (e.g., 3 or more stacked layers) while the first and second portions have a fewer number of material layers (e.g., only a single material layer). Due to the process of forming the multi-layer spacer structure initially on the sidewalls of both the gate and source or drain regions, the layers can be selectively peeled away to expose a wider area for forming the source or drain regions. Numerous variations and embodiments will be apparent in light of this disclosure.

### General Overview

As previously noted above, there remain a number of non-trivial challenges with respect to spacer formation. In more detail, spacers are typically provided along the sidewalls of gate structures or sacrificial gate structures to define part of the device's gate length and to determine locations of grown epitaxial source and drain regions. According to some embodiments, the spacer structures are also used to constrain and/or define the region for the growth of the source or drain material. However, leveraging such spacer structures for multiple purposes can be challenging as the spacers are more difficult to control than typical planar layers.

Thus, and in accordance with an embodiment of the present disclosure, techniques are provided herein to form multi-layered spacer structures across different regions of a semiconductor device. The spacer structure may include multiple dielectric layers having compositionally different materials that exhibit high etch selectivity to one another. In this way, particular layers of the spacer structure can be selectively removed to effectively trim the thickness of the spacer layer. According to some embodiments, the thickness of the spacer structure adjacent to the source or drain regions is thinned to allow for the formation of a wider source or drain region within the confines of the spacer structure. Furthermore, the process performed to remove certain layers from the spacer structure near the source or drain region can also be used to simultaneously remove certain layers from the spacer structure along a sidewall of the gate or sacrificial gate. As used herein, the term "along" means that a structure is closely adjacent to (e.g., within 20 nm of) and runs in the same direction (e.g., parallel to) another structure. For example, a layer that is along a sidewall of a gate runs in the same direction (e.g., parallel to) the gate sidewall and is within 20 nm of the sidewall of the gate. Additionally, a layer can be along a structure without being directly on the structure such that one or more intervening layers could exist between the layer and the structure.

According to an embodiment, an integrated circuit includes a semiconductor device having a semiconductor region extending between a source region and a drain region, a gate layer extending over the semiconductor region, and a spacer structure. The spacer structure includes a first spacer portion adjacent to the gate layer, a second spacer portion adjacent to the source region or the drain region, and a third spacer portion between the first and second spacer portions. The first spacer portion includes a first layer of first dielectric material along a sidewall of the gate layer. The second spacer portion includes a second layer of second dielectric material along a sidewall of the source region or drain region. The third spacer portion includes the first layer of first dielectric material, the second layer of second dielectric material, and a third layer of third dielectric material compositionally different than the first and second dielectric materials.

According to another embodiment, an electronic device includes a chip package having one or more dies. At least one of the one or more dies includes a semiconductor device having a semiconductor region extending between a source region and a drain region, a gate layer extending over the semiconductor region, and a spacer structure. The spacer structure includes a first spacer portion adjacent to the gate layer, a second spacer portion adjacent to the source region or the drain region, and a third spacer portion between the first and second spacer portions. A first layer of first dielectric material extends along a sidewall of the gate layer in the first spacer portion and the first layer extends into the third spacer portion. A second layer of second dielectric material extends along a sidewall of the source region or drain region in the second spacer portion and the second layer extends into the third spacer portion. A third layer of third dielectric material compositionally different than the first and second dielectric materials extends within the third spacer portion along with the first and second layers.

According to another embodiment, a method of forming an integrated circuit includes forming a fin comprising semiconductor material on a substrate; forming a sacrificial gate over a portion of the fin, such that a first portion of the fin is beneath the sacrificial gate and a second portion of the fin is adjacent to the sacrificial gate; forming a first layer of a spacer structure along a sidewall of the sacrificial gate and along a sidewall of the second portion of the fin, the first layer comprising a first dielectric material; forming a second layer of the spacer structure on the first layer along the sidewall of the sacrificial gate and along the sidewall of the second portion of the fin, the second layer comprising a second dielectric material; forming a third layer of the spacer structure on the second layer along the sidewall of the sacrificial gate and along the sidewall of the second portion of the fin, the third layer comprising a third dielectric material; removing the spacer structure from a top surface of the second portion of the fin; removing the second portion of the fin leaving behind a cavity; and simultaneously removing the first layer of the spacer structure adjacent to the cavity and the third layer of the spacer structure along the sidewall of the sacrificial gate.

The techniques can be used with any type of non-planar transistors, including finFETs (sometimes called double-gate transistors, or tri-gate transistors), or nanowire and nanoribbon transistors (sometimes called gate-all-around transistors), to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of three different material layers making up a portion of a spacer structure that extends along a side of the gate and along a side of the source and drain regions of a given semiconductor device. In some embodiments, the portion of the spacer structure having the stack of three material layers is between, and in contact with, both (1) a first portion that runs along the sidewall of the gate and (2) a second portion that runs along the side of the source or drain region. The first and second portions of the spacer structure may not include all three of the material layers. In some other example embodiments, such tools may indicate wider-than-usual source or drain regions due to the thinned spacer structures surrounding the epitaxial material growth for the source or drain regions. Numerous configurations and variations will be apparent in light of this disclosure.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different from SiGe having 25 atomic percent germanium). In addition to such chemical composition diversity, the materials may also have distinct dopants (e.g., phosphorus, arsenic, boron, gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer.

### Architecture

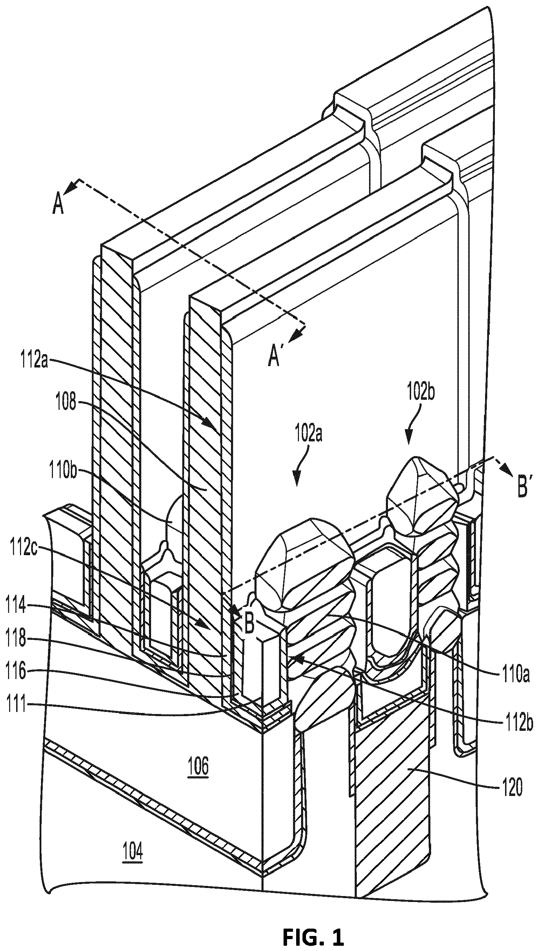

Figure 1 is an isometric view of a portion of an integrated circuit that includes two semiconductor devices 102a and 102b, in accordance with an embodiment of the present disclosure. Semiconductor devices 102a and 102b may be non-planar metal oxide semiconductor (MOS) transistors, such as tri-gate or gate-all-around transistors, although other transistor topologies and types could also benefit from the techniques provided herein.

As can be seen, semiconductor devices 102a and 102b are formed on a substrate 104. Any number of semiconductor devices can be formed on substrate 104, but two are used here as an example. Substrate 104 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, the substrate can be a semiconductor-on-insulator substrate having a desired semiconductor layer over a buried insulator layer (e.g., silicon over silicon dioxide). Alternatively, the substrate can be a multi-layer substrate or superlattice suitable for forming nanowires or nanoribbons (e.g., alternating layers of silicon and SiGe, or alternating layers indium gallium arsenide and indium phosphide). Any number of substrates can be used.

The semiconductor material in each of semiconductor devices 102a and 102b may be formed from substrate 104. Semiconductor devices 102a and 102b may each include fins (not seen in this view as they are beneath various other layers) that can be, for example, native to substrate 104 (formed from the substrate itself), such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around process can then be carried out. Again, the alternating layers can be blanket deposited and then etched into fins or deposited into fin-shaped trenches.

As can further be seen, semiconductor devices 102a and 102b are separated by a dielectric fill 106 that may include silicon oxide. Dielectric fill 106 provides shallow trench isolation (STI) between adjacent semiconductor devices. Dielectric fill 106 can be any suitable dielectric material, such as silicon dioxide, aluminum oxide, or silicon oxycarbonitride.

A gate layer 108 extends over the semiconductor material of both semiconductor devices 102a and 102b in this example. The semiconductor material is not shown as it is surrounded by gate layer 108. In other examples, different gate layers are used in each of semiconductor devices 102a and 102b. Gate layer 108 may include any sufficiently conductive material such as a metal, metal alloy, or doped polysilicon.

Each of semiconductor devices 102a and 102b includes a first source or drain region 110a and a second source or drain region 110b such that the semiconductor material of a given semiconductor device extends between the corresponding first source or drain region 110a and second source or drain region 110b. According to some embodiments, the source or drain regions 110a and 110b are epitaxial source or drain regions that are provided on the fins in an etch-and-replace process. In other embodiments one or both of source or drain regions 110a and 110b could be, for example, implantation-doped native portions of the fins or substrate. Any semiconductor materials suitable for source and drain regions can be used (e.g., group IV and group III-V semiconductor materials). source or drain regions 110a and 110b may include multiple layers such as liners and capping layers to improve contact resistance. In any such cases, the composition and doping of source or drain regions 110a and 110b may be the same or different, depending on the polarity of the transistors. In an example, for instance, one transistor is a p-type MOS (PMOS) transistor, and the other transistor is an n-type MOS (NMOS) transistor. Any number of source and drain configurations and materials can be used. According to some embodiments, a second dielectric fill 111 is provided between adjacent source or drain regions. Second dielectric fill 111 can be any suitable dielectric material, such as silicon dioxide, aluminum oxide, or silicon oxycarbonitride.

According to some embodiments, a spacer structure runs along a sidewall of gate layer 108 and a side of source or drain region 110a (also along a side of source or drain region 110b). The spacer structure can be thought of as having three portions, 112a, 112b and 112c. In particular, a first spacer portion 112a runs along a side of gate layer 108, a second spacer portion 112b runs along a side of source or drain region 110a, and a third spacer portion 112c connects between first spacer portion 112a and second spacer portion 112b in the region beneath second dielectric fill 111 and between second dielectric fill 111 and gate layer 108. According to some embodiments, the first spacer portion 112a and the second spacer portion 112b each include a dielectric layer having the same material composition. In one example, a first dielectric layer 114 in first spacer portion 112a and a second dielectric layer 116 in the second spacer portion 112b includes silicon and one or more of oxygen, carbon, and nitrogen. Third spacer portion 112c includes a stack of different dielectric layers, such as a third dielectric layer 118 between first dielectric layer 114 and second dielectric layer 116. According to some embodiments, third dielectric layer 118 includes a different material composition than either first dielectric layer 114 or second dielectric layer 116 such that there is a relatively high etch selectivity between third dielectric layer 118 and either first dielectric layer 114 or second dielectric layer 116. Although only three dielectric layers are illustrated in third spacer portion 112c, any number of dielectric layers may be included. Due to the fabrication process as will be described in more detail herein, the stacked dielectric layers observed in the third spacer portion 112c (e.g., three different dielectric layers) are not observed in either first spacer portion 112a or second spacer portion 112b.

In some embodiments, a buried conductive layer 120 is provided within the substrate and adjacent to one or more of the semiconductor devices. The presence of the buried conductive layer 120 is optional and can be used to provide VDD or VSS power rails to various semiconductor devices of the integrated circuit.

### Fabrication Methodology

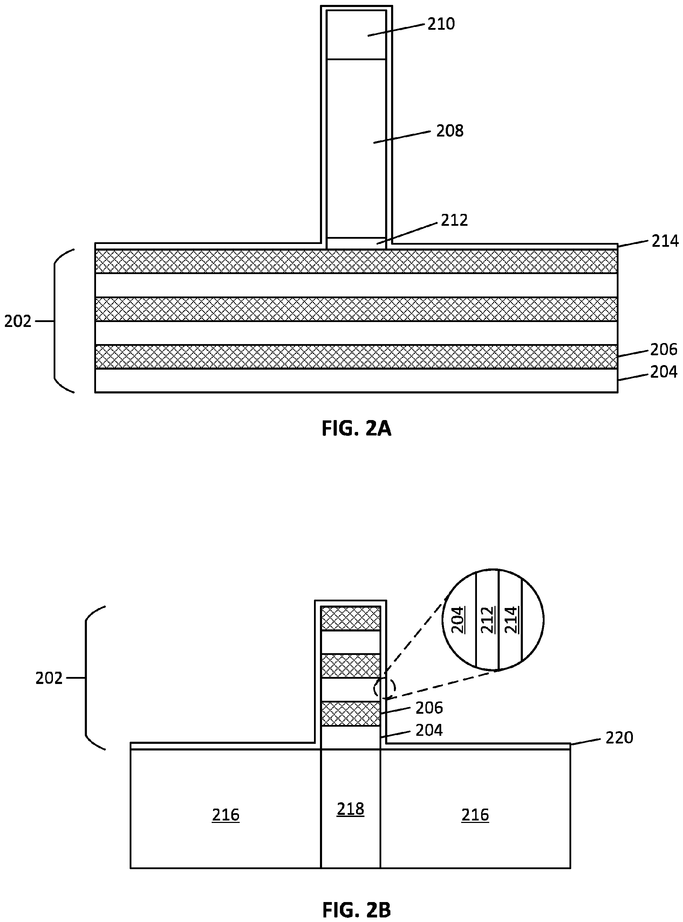

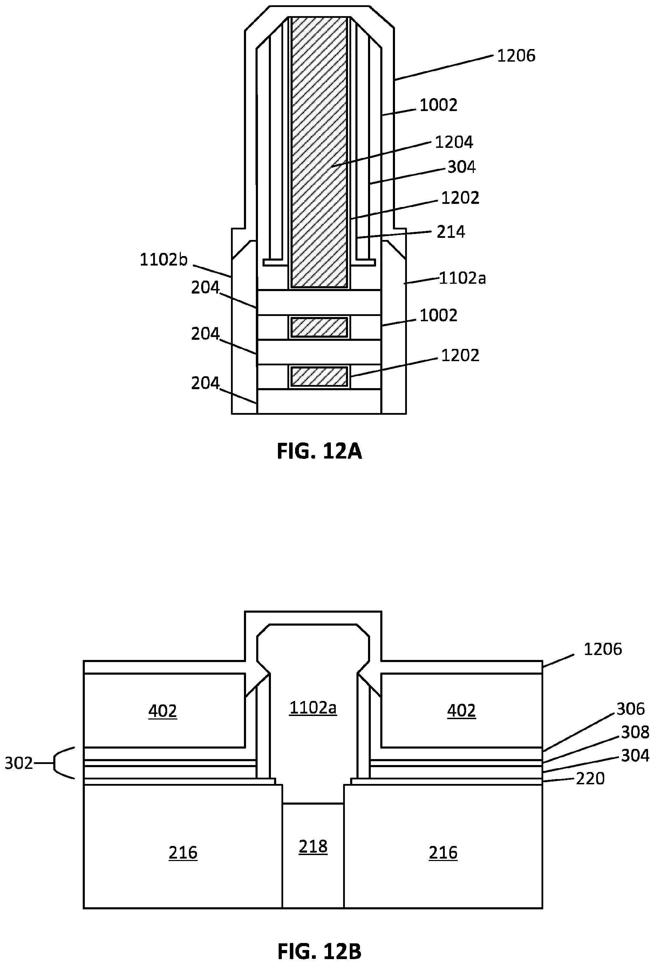

Figures 2A - 12A and 2B -12B are cross-sectional views that collectively illustrate an example process for forming an integrated circuit configured with a multi-layer spacer structure, in accordance with an embodiment of the present disclosure. Figures 2A - 12A represent a cross-sectional view taken across plane A - A' as seen in Figure 1, while figures 2B - 12B represent a cross-sectional view taken across plane B - B' as seen in Figure 1. Each figure shows an example structure that results from the process flow up to that point in time, so the depicted structure evolves as the process flow continues, culminating in the structure shown in Figures 12A and 12B, which is similar to the structure shown in Figure 1. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated. Figures sharing the same number (e.g., Figures 2A and 2B) illustrate different views of the structure at the same point in time during the process flow.

Figures 2A and 2B illustrate cross-sectional views taken through and parallel to a fin 202 of one of the semiconductor devices (Figure 2A) and taken across the area where the source or drain region will be that is perpendicular to a length of fin 202 (Figure 2B). In this example, fin 202 includes alternating layers of material in order to ultimately form nanowires or nanoribbons in a gate-all-around (GAA) structure. In other examples, fin 202 includes a single semiconductor material (e.g., silicon or germanium).

In this example, fin 202 includes alternating layers of semiconductor material 204 and sacrificial layers 206. Semiconductor material 204 may include silicon, germanium, or an alloy thereof. Sacrificial layers 206 have a different material composition than semiconductor material 204. In some embodiments, sacrificial layers 206 include some combination of silicon and germanium.

As seen in Figure 2A, a sacrificial gate 208 is patterned over fin 202 and runs in an orthogonal direction to a length of fin 202. Sacrificial gate 208 may include any material that can be safely removed later in the process without etching or otherwise damaging the sidewall spacers and/or fin 202. In some embodiments, sacrificial gate 208 includes a cap layer 210 that is used to define the pattern of sacrificial gate 208 during a reactive ion etching (RIE) process. In some examples, cap layer 210 comprises silicon nitride while sacrificial gate 208 comprises polysilicon. In some embodiments, sacrificial gate 208 is formed over a protective dielectric layer 212 that may include silicon oxide. Protective dielectric layer 212 may extend over fin 202 in other areas than just beneath sacrificial gate 208. In some embodiments, a dielectric liner 214 is deposited over fin 202 and over sacrificial gate 208. Dielectric liner 214 may include silicon nitride.

As seen in Figure 2B, fin 202 extends above a dielectric fill 216 that acts as an STI region between adjacent fins (other fins are not shown for clarity). Dielectric fill 216 may include silicon oxide. According to some embodiments, the semiconductor device includes a subfin portion 218 beneath fin 202 and between dielectric fill 216. Subfin portion 218 may include the same material as the semiconductor substrate and may be an integral part of the semiconductor substate that would extend below dielectric fill 216. According to some embodiments, another dielectric liner 220 is present over the portion of fin 202 that is not under sacrificial gate 208. In some examples, dielectric liner 220 is the same as dielectric liner 214. However, in some other examples, dielectric liner 220 includes a stack of different dielectric layers. In the illustrated magnified example, dielectric liner 220 includes a layer stack having protective dielectric layer 212 and dielectric liner 214.

While dimensions can vary from one example embodiment to the next, in one example case, the total height of fin 202 (e.g., extending above dielectric fill 216) may be between 50 nm and 150 nm, and the width of fin 202 can be, for example, in the range of 5 to 100 nm. The thickness of each layer of semiconductor material 204 and sacrificial layer 206 may be between about 5 nm and about 25 nm. The thickness of protective dielectric layer and dielectric liner 214 may each be between about 1 nm and about 10 nm.

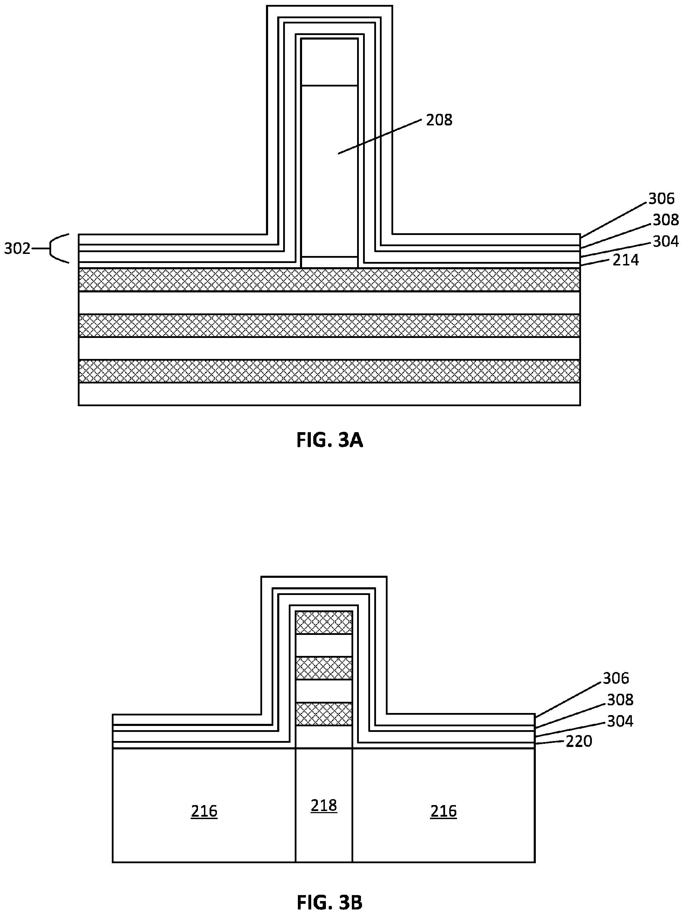

Figures 3A and 3B depict the cross-section views of the structure shown in Figures 2A and 2B, respectively, following the formation of a spacer structure 302. As discussed above, spacer structure 302 includes multiple dielectric layers deposited one over the other. In some examples, spacer structure 302 includes a first dielectric layer 304, a second dielectric layer 306, and a third dielectric layer 308 sandwiched between first dielectric layer 304 and second dielectric layer 306. In some embodiments, first dielectric layer 304 and second dielectric layer 306 comprise the same material and may each include silicon oxycarbonitride while third dielectric layer 308 includes a compositionally different dielectric material, such as silicon oxide. Each of the dielectric layers that make up spacer structure 302 may be deposited using any conventional deposition technique, such as chemical vapor deposition (CVD), plasma-enhanced chemical vapor deposition (PECVD), or atomic layer deposition (ALD). According to some embodiments, third dielectric layer 308 is thinner than both first dielectric layer 304 and second dielectric layer 306, which may each have about the same thickness. In one example, first dielectric layer 304 and second dielectric layer 306 have a thickness between about 1 nm and about 20 nm and third dielectric layer 308 has a thickness between about 1 nm and about 10 nm.

According to some embodiments, an additional dielectric capping layer may be deposited over spacer structure 302. The additional dielectric capping layer may include a compositionally different dielectric material than any of the layers within spacer structure 302, such as for example silicon nitride.

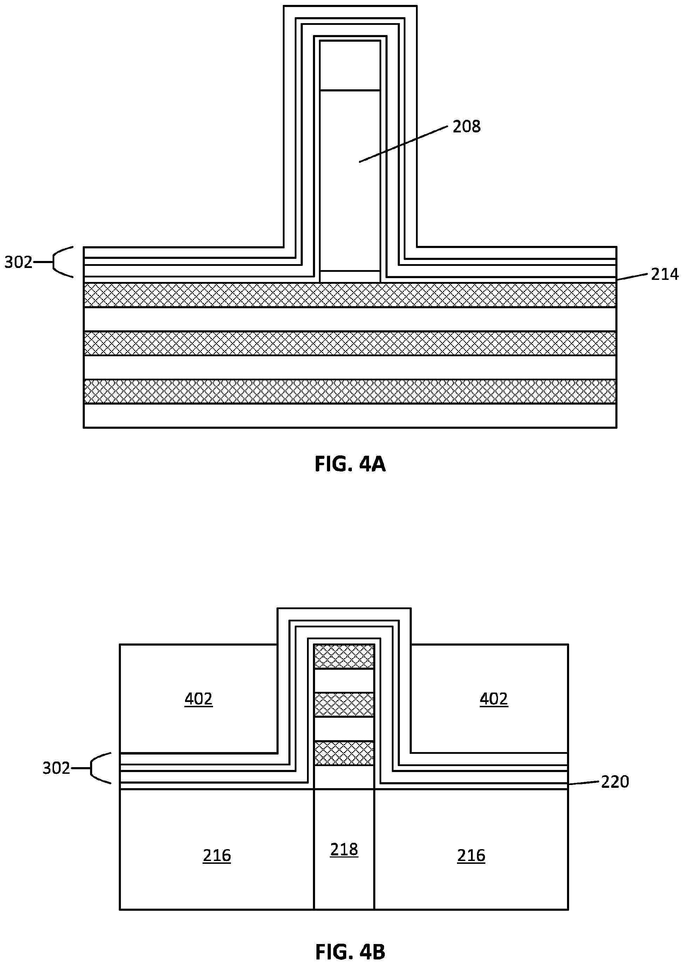

Figures 4A and 4B depict the cross-section views of the structure shown in Figures 3A and 3B, respectively, following the formation of a second dielectric fill 402. Second dielectric fill 402 may be any suitable dielectric material, such as silicon oxide and deposited using any conventional deposition technique, such as CVD or PECVD. According to some embodiments, second dielectric fill 402 is initially deposited to a thickness greater than the height of the fin and is polished back (e.g., using chemical mechanical polishing) followed by an etch recess process to bring it to a final height that at least exposes the top portion of spacer structure 302 above the fin as shown in Figure 4B. Once second dielectric fill 402 has been recessed to the height shown in Figure 4B, it would not be seen in the cross-section view of Figure 4A.

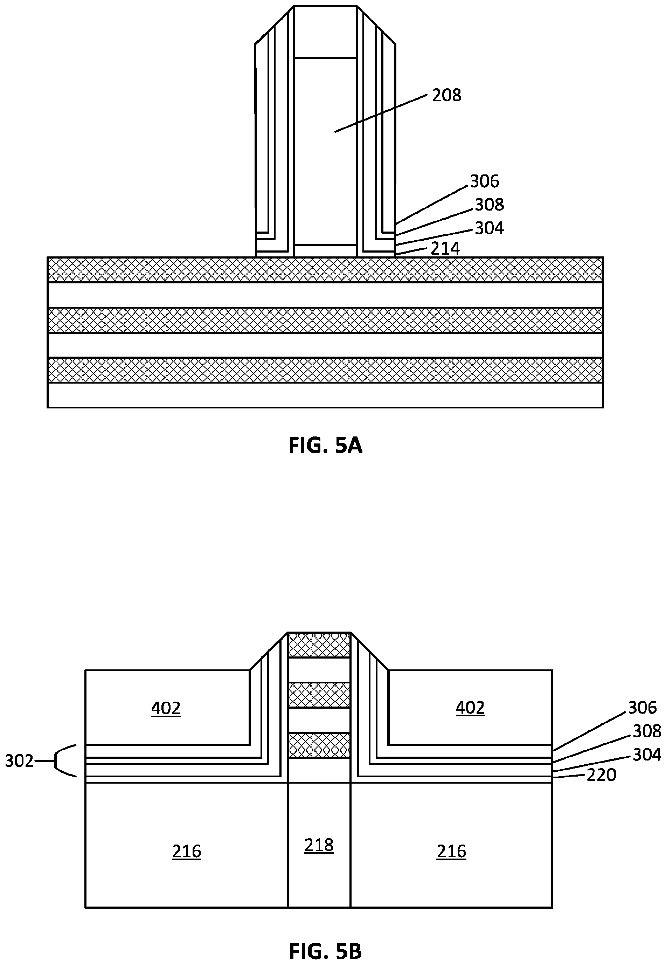

Figures 5A and 5B depict the cross-section views of the structure shown in Figures 4A and 4B, respectively, following the removal of the top portion of spacer structure 302 over the fin. According to some embodiments, an RIE process is carried out to directionally etch through all dielectric layers of spacer structure 302 in a substantially vertical direction. Due to the directionality of the etch, exposed horizontal portions of spacer structure 302 are removed while the vertical portions of spacer structure 302 along the sidewall of sacrificial gate 208 and along the sidewall of the fin not under sacrificial gate 208 remain. According to some embodiments, the topside sidewall portions of spacer structure 302 will show signs of being vertically etched to some degree. In some examples, the directional RIE process also removes the exposed horizontal portions of dielectric liner 214 over the top of sacrificial gate 208 and also the exposed horizontal portions of dielectric liner 220 above the fin. Note that all dielectric layers of spacer structure 302 remain intact beneath second dielectric fill 402 as they are protected from the RIE process by second dielectric fill 402.

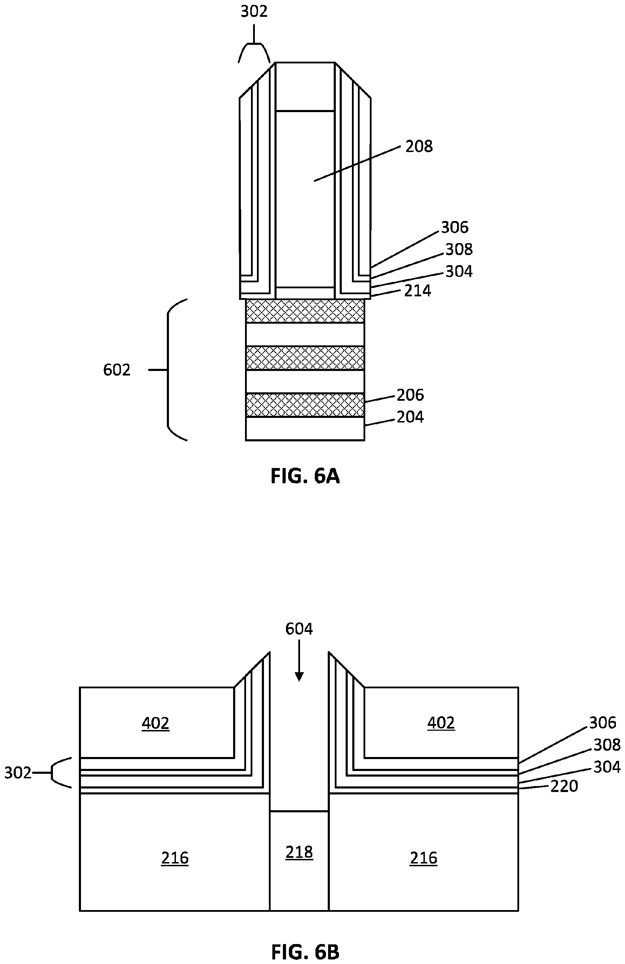

Figures 6A and 6B depict the cross-section views of the structure shown in Figures 5A and 5B, respectively, following the removal of the exposed fin not under sacrificial gate 208. According to some embodiments, both layers of semiconductor material 204 and sacrificial layers 206 are etched at substantially the same rate using an anisotropic RIE process. As observed in Figure 6A, the width of spacer structure 302 works to define the length of the shorter fin 602 (e.g., the length of the device channel). In some embodiments, some undercutting occurs along the edges of fin 602 beneath spacer structure 302 such that the length is not exactly the same as a sum of the widths of spacer structures 302 and a width of sacrificial gate 208. As observed in Figure 6B, the fin is completely removed leaving behind a cavity 604 in which the source or drain regions will be formed, according to some embodiments. The RIE process may also etch into subfin 218 thus recessing subfin 218 beneath a top surface of dielectric fill 216.

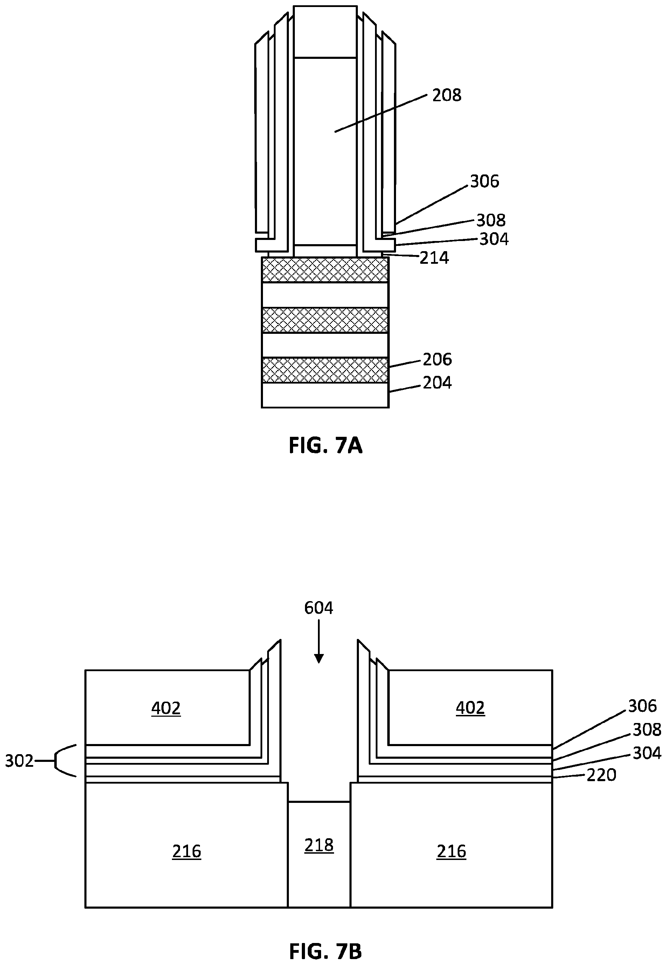

Figures 7A and 7B depict the cross-section views of the structure shown in Figures 6A and 6B, respectively, following the removal of dielectric liner 220 from within cavity 604. As discussed above, dielectric liner 220 may include one or more compositionally different dielectric layers. In one example, dielectric liner 220 includes at least one layer comprising silicon oxide and at least one layer comprising silicon nitride. Thus, in some embodiments, more than one isotropic etch process may be used to remove the different dielectric layers that make up dielectric liner 220. Wet isotropic etch processes may be used to remove the various dielectric layers of dielectric liner 220 from the sides of cavity 604.

According to some embodiments, the isotropic etch process used to remove any silicon oxide layers from dielectric liner 220 will also partially etch exposed portions of third dielectric layer 308 as seen in both Figures 7A and 7B. According to some embodiments, the isotropic etch process used to remove any silicon nitride layers from dielectric liner 220 will also partially etch exposed portions of dielectric liner 214 as seen in Figure 7A.

Following the removal of dielectric liner 220 from the sides of cavity 604, the width of cavity 604 is defined by the presence of spacer structure 302. According to some embodiments, this width of cavity 604 can now be carefully controlled by peeling away one or more layers of spacer structure 302 through selective isotropic etch processes.

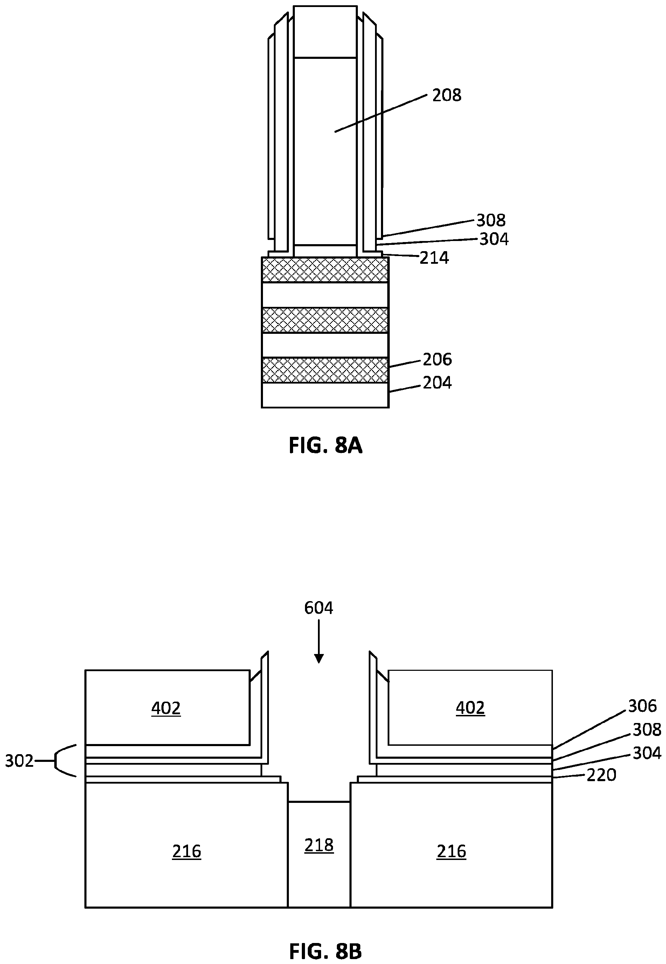

Figures 8A and 8B depict the cross-section views of the structure shown in Figures 7A and 7B, respectively, following the removal of first dielectric layer 304 from along the side of cavity 604 and the removal of second dielectric layer 306 from along the side of sacrificial gate 208. An isotropic wet etching process may be used to simultaneously remove the exposed first dielectric layer 304 from along the side of cavity 604 and the exposed second dielectric layer 306 from along the side of sacrificial gate 208. The simultaneous removal can be made possible if first dielectric layer 304 and second dielectric layer 306 are the same material. Additionally, the isotropic etching of first dielectric layer 304 and second dielectric layer 306 is selective and does not substantially etch third dielectric layer 308, according to some embodiments. Some exposed portions of second dielectric layer 306 along the side of cavity 604 and some exposed portions of first dielectric layer 304 along the side of sacrificial gate 208 may be etched as observed in both Figures 8A and 8B.

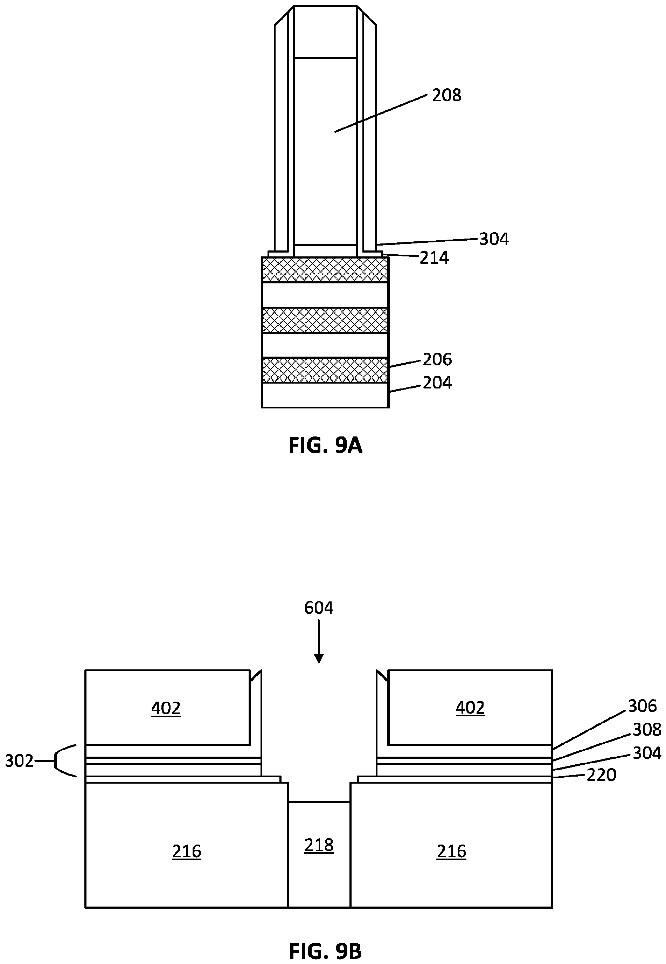

Figures 9A and 9B depict the cross-section views of the structure shown in Figures 8A and 8B, respectively, following the removal of third dielectric layer 308 from along the side of cavity 604 and from along the side of sacrificial gate 208. An isotropic wet etching process may be used to simultaneously remove the same third dielectric layer 308 from along the sides of both cavity 604 and sacrificial gate 208. According to some embodiments, the etchants used to remove third dielectric layer 308 exhibit little to no etching of the exposed first dielectric layer 304 and second dielectric layer 306. By selectively removing dielectric layers from spacer structure 302, the width of cavity 604 has been increased while simultaneously decreasing the width of spacer structure 302 present along the sidewall of sacrificial gate 208. Note that all dielectric layers of spacer structure 302 remain intact beneath second dielectric fill 402.

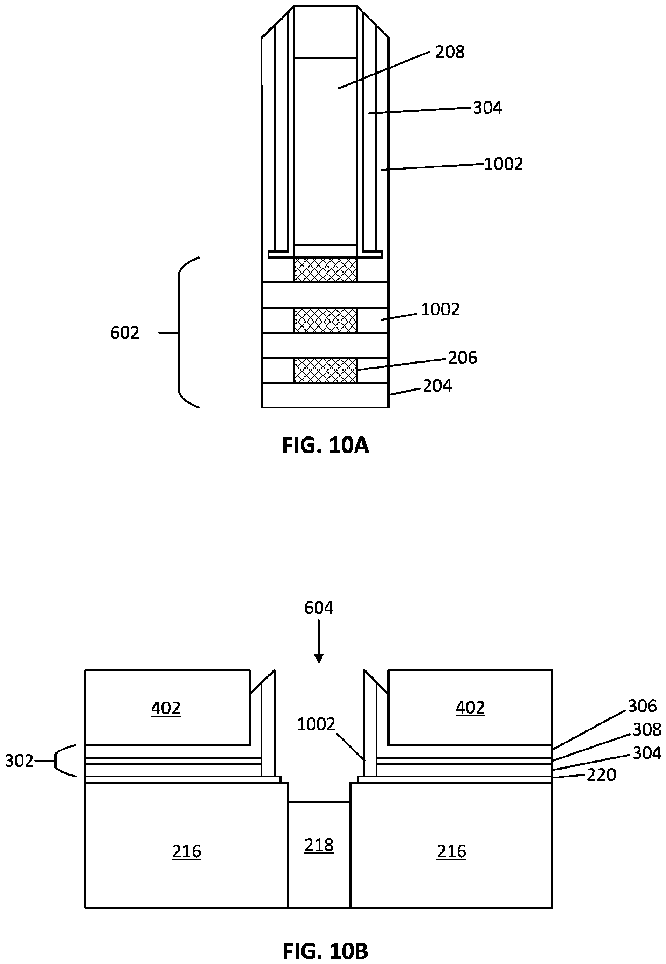

Figures 10A and 10B depict the cross-section views of the structure shown in Figures 9A and 9B, respectively, following the formation of an additional dielectric layer 1002. According to some embodiments, prior to the deposition of dielectric layer 1002, the exposed ends of sacrificial layers 206 within fin 602 are laterally recessed using an isotropic etching process that selectively etches sacrificial layers 206 as opposed to the layers of semiconductor material 204. Afterwards, another dielectric layer 1002 is deposited to effectively fill the dimples between the layers of semiconductor material 204, according to some embodiments. Dielectric layer 1002 can then be etched back using RIE or a wet isotropic etch at least until the ends of layers of semiconductor material 204 are exposed, however, dielectric layer 1002 remains around portions of semiconductor material 204 near its ends and a partial thickness of layer 1002 can remain on the sidewalls of sacrificial gate 208 and along sides of cavity 604.

According to some embodiments, dielectric layer 1002 has the same material composition as both first dielectric layer 304 and second dielectric layer 306. Accordingly, although dielectric layer 1002 may remain along the sides of sacrificial gate 208 and along the sides of cavity 604, a seam may or may not exist between dielectric layer 1002 and the underlying first dielectric layer 304 or second dielectric layer 306. It should be noted that this additional dielectric layer 1002 may only be present when using a gate-all-around (GAA) structure having semiconductor nanoribbons or nanowires.

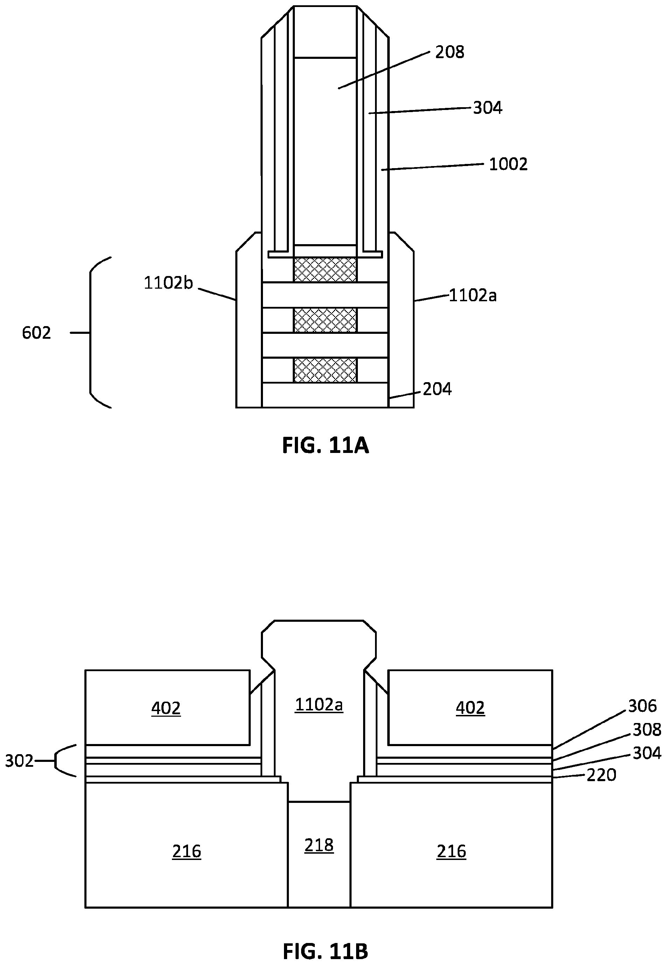

Figures 11A and 11B depict the cross-section views of the structure shown in Figures 10A and 10B, respectively, following the formation of source or drain regions 1102a and 1102b on either side of fin 602. According to some embodiments, source or drain region 1102a is epitaxially grown from the exposed semiconductor material on the top surface of subfin 218 within cavity 604. A corresponding source or drain region 1102b is similarly formed on the opposite end of fin 602 to form both source and drain regions. In some example embodiments, source or drain regions 1102a and 1102b are NMOS source or drain regions (e.g., epitaxial silicon) or PMOS source or drain regions (e.g., epitaxial SiGe). Note that the width of source or drain region 1102a is controlled based on the number of dielectric layers that were removed from spacer structure 302. A wider source or drain region 1102a provides numerous benefits such as increased stress for the structure and increased carrier mobility in the adjacent, strained channel.

Figures 12A and 12B depict the cross-section views of the structure shown in Figures 11A and 11B, respectively, following the completion of the transistor structure. Once the source or drain regions 1102a and 1102b are formed, sacrificial gate 208 is removed using a wet or dry isotropic process thus exposing the various alternating layers of fin 602. At this point, sacrificial layers 206 are removed using a selective etching isotropic etching process that removes the material of sacrificial layers 206 but does not remove (or removes very little of) the layers of semiconductor material 204. At this point, the exposed layers of semiconductor material 204 form nanoribbons or nanowires that extend between source or drain regions 1102a and 1102b.

The exposed layers of semiconductor material 204 within the trench left behind following the removal of sacrificial gate 208 are coated with a gate dielectric 1202. Gate dielectric 1202 may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 1202 is hafnium oxide with a thickness between about 1 nm and about 5 nm. In some embodiments, the gate dielectric 1202 may include one or more silicates (e.g., titanium silicate, tungsten silicate, niobium silicate, and silicates of other transition metals). Gate dielectric 1202 may be a multi-layer structure, in some examples. For instance, gate dielectric 1202 may include a first layer on semiconductor material 204, and a second layer on the first layer. The first layer can be, for instance, an oxide of semiconductor material 204 (e.g., silicon dioxide) and the second layer can be a high-k dielectric material (e.g., hafnium oxide). In some embodiments, an annealing process may be carried out on gate dielectric 1202 to improve its quality when high-k dielectric material is used. In some embodiments, the high-K material can be nitridized to improve its aging resistance.

Once gate dielectric 1202 has been deposited, a gate 1204 is formed within the trench left behind after the removal of sacrificial gate 208 and around one or more of the layers of semiconductor material 204. Gate 1204 can be any standard or proprietary gate structure and may include any number of gate cuts. In some embodiments, gate 1204 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate 1204 may include, for instance, a metal plug along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

According to some embodiments, a cap layer 1206 may be deposited over gate 1204 and over source or drain regions 1102a and 1102b. Cap layer 1206 can protect the underlying conductive structures of the transistor from further circuit fabrication processes. In some examples, cap layer 1206 comprises silicon nitride. One or more contacts can be formed by punching a hole through cap layer 1206 over either gate 1204 or source or drain regions 1102a and 1102b and filling the hole (e.g., contact via) with metal.

According to some embodiments, the final structure yields a finFET or GAA semiconductor device with a spacer structure 302 having three defined portions: a first portion, a second portion, and a third portion. The first portion of the spacer structure 302 is along a sidewall of gate 1204 and includes first dielectric layer 304 (and does not include second or third dielectric layers 306 and 308). The second portion of the gate structure 302 is along a sidewall of source or drain region 1102a or 1102b and includes second dielectric layer 306 (and does not include first or third dielectric layers 304 and 308). The third portion of the spacer structure 302 is between, and in contact with, the first and second portions (e.g., protected beneath second dielectric fill 402). According to some embodiments, the third portion of the spacer structure 302 includes the first dielectric layer 304 from the first portion of the spacer structure 302, the second dielectric layer 306 from the second portion of the spacer structure 302, and the third dielectric layer 308 between the first and second dielectric layers 304 and 306. Put another way, the first dielectric layer 304 extends between the first portion of the spacer structure 302 along the sidewall of gate 1204 and the third portion of the spacer structure, the second dielectric layer 306 extends between the second portion of the spacer structure 302 along the sidewall of source or drain region 1102a or 1102b and the third portion of the spacer structure, and the third dielectric layer 308 extends only within the third portion of the spacer structure, according to some embodiments.

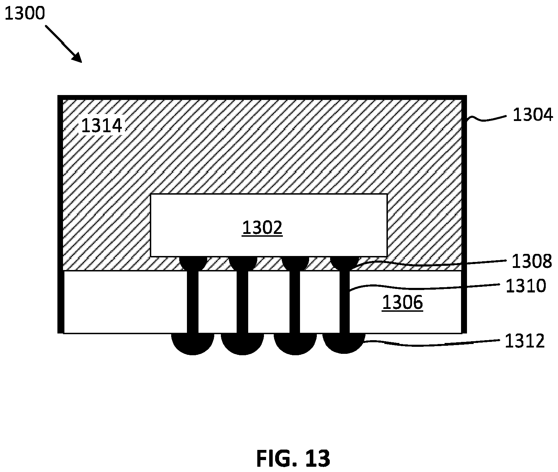

Figure 13 illustrates an example embodiment of a chip package 1300. As can be seen, chip package 1300 includes one or more dies 1302. One or more dies 1302 may include at least one integrated circuit having semiconductor devices, such as any of the semiconductor devices disclosed herein. One or more dies 1302 may include any other circuitry used to interface with other devices formed on the dies, or other devices connected to chip package 1300, in some example configurations.

As can be further seen, chip package 1300 includes a housing 1304 that is bonded to a package substrate 1306. The housing 1304 may be any standard or proprietary housing, and provides, for example, electromagnetic shielding and environmental protection for the components of chip package 1300. The one or more dies 1302 may be conductively coupled to a package substrate 1306 using connections 1308, which may be implemented with any number of standard or proprietary connection mechanisms, such as solder bumps, ball grid array (BGA), pins, or wire bonds, to name a few examples. Package substrate 1306 may be any standard or proprietary package substrate, but in some cases includes a dielectric material having conductive pathways (e.g., including conductive vias and lines) extending through the dielectric material between the faces of package substrate 1306, or between different locations on each face. In some embodiments, package substrate 1306 may have a thickness less than 1 millimeter (e.g., between 0.1 millimeters and 0.5 millimeters), although any number of package geometries can be used. Additional conductive contacts 1312 may be disposed at an opposite face of package substrate 1306 for conductively contacting, for instance, a printed circuit board (PCB). One or more vias 1310 extend through a thickness of package substrate 1306 to provide conductive pathways between one or more of connections 1308 to one or more of contacts 1312. Vias 1310 are illustrated as single straight columns through package substrate 1306 for ease of illustration, although other configurations can be used (e.g., damascene, dual damascene, through-silicon via). In still other embodiments, vias 1310 are fabricated by multiple smaller stacked vias, or are staggered at different locations across package substrate 1306. In the illustrated embodiment, contacts 1312 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1312, to inhibit shorting.

In some embodiments, a mold material 1314 may be disposed around the one or more dies 1302 included within housing 1304 (e.g., between dies 1302 and package substrate 1306 as an underfill material, as well as between dies 1302 and housing 1304 as an overfill material). Although the dimensions and qualities of the mold material 1314 can vary from one embodiment to the next, in some embodiments, a thickness of mold material 1314 is less than 1 millimeter. Example materials that may be used for mold material 1314 include epoxy mold materials, as suitable. In some cases, the mold material 1314 is thermally conductive, in addition to being electrically insulating.

### Methodology

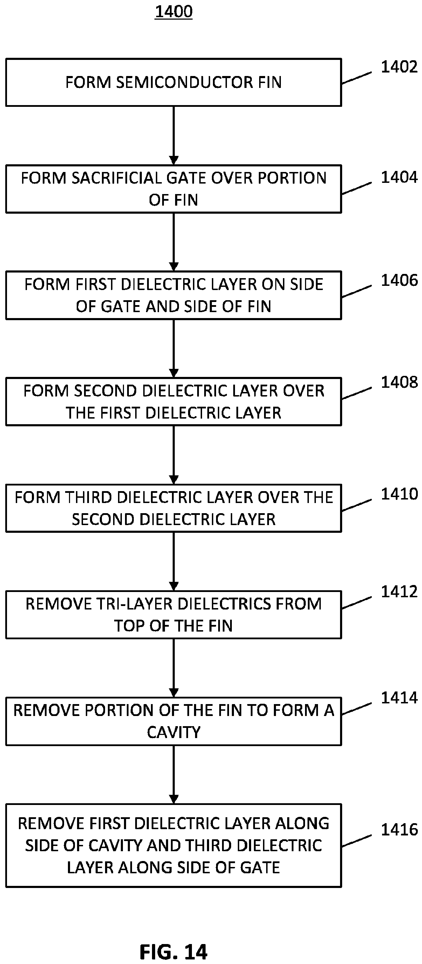

Figure 14 is a flow chart of a method 1400 for forming at least a portion of an integrated circuit, according to an embodiment. Various operations of method 1400 may be illustrated in Figures 2A - 12A and 2B - 12B. However, the correlation of the various operations of method 1400 to the specific components illustrated in the aforementioned figures is not intended to imply any structural and/or use limitations. Rather, the aforementioned figures provide one example embodiment of method 1400. Other operations may be performed before, during, or after any of the operations of method 1400. Some of the operations of method 1400 may be performed in a different order than the illustrated order.

Method 1400 begins with operation 1402 where at least one semiconductor fin is formed, according to some embodiments. The semiconductor material in the fin may be formed from a substrate such that the fin is an integral part of the substrate (e.g., etched from a bulk silicon substrate). Alternatively, the fin can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around process can then be carried out. Again, the alternating layers can be blanket deposited and then etched into fins, or deposited into fin-shaped trenches.

Method 1400 continues with operation 1404 where a sacrificial gate is formed over a portion of the fin, according to some embodiments. The sacrificial gate may include any material that can be safely removed later in the process without etching or otherwise damaging the sidewall spacers and/or the fin. In some embodiments, the sacrificial gate includes a cap layer that is used to lithographically define the pattern of the sacrificial gate during a RIE process. In some examples, the cap layer comprises silicon nitride while the sacrificial gate comprises polysilicon.

Method 1400 continues with operation 1406 where a first dielectric layer is formed along sidewalls of the sacrificial gate and along sidewalls of the exposed fin (e.g., outside from underneath the sacrificial gate), according to some embodiments. The first dielectric layer may be the first layer of a multi-layer spacer structure. In some embodiments, the first dielectric layer comprises silicon oxycarbonitride and may be deposited using any conventional deposition technique, such as CVD, PECVD, or ALD.

Method 1400 continues with operation 1408 where a second dielectric layer is formed over the first dielectric layer and along the sidewalls of the sacrificial gate and along sidewalls of the exposed fin (e.g., outside from underneath the sacrificial gate), according to some embodiments. The second dielectric layer may be the second layer of the multi-layer spacer structure. In some embodiments, the second dielectric layer is thinner than the first dielectric layer and comprises silicon oxide and may be deposited using any conventional deposition technique, such as CVD, PECVD, or ALD. Second dielectric layer may be any dielectric material that has a different material composition than the first dielectric layer.

Method 1400 continues with operation 1410 where a third dielectric layer is formed over the second dielectric layer and along the sidewalls of the sacrificial gate and along sidewalls of the exposed fin (e.g., outside from underneath the sacrificial gate), according to some embodiments. The third dielectric layer may be the third layer of the multi-layer spacer structure. In some embodiments, the third dielectric layer is substantially the same as the first dielectric layer and may be deposited using any conventional deposition technique, such as CVD, PECVD, or ALD.

Method 1400 continues with operation 1412 where the various dielectric layers of the multi-layer spacer structure are removed at least from over the top surface of the fin, according to some embodiments. The dielectrics may be removed using a directional RIE process which also removes the dielectric layers of the multi-layer spacer structure from over the top surface of the sacrificial gate. Following the etching process, the various dielectric layers of the multi-layer spacer structure remain along the sidewalls of the sacrificial gate and along the sidewalls of the fin outside from underneath the sacrificial gate.

Method 1400 continues with operation 1414 where the exposed portion of the fin is removed to form a cavity on either side of the fin portion beneath the sacrificial gate, according to some embodiments. The fin may be removed using a directional RIE process that selectively removes silicon-based semiconductor materials. Accordingly, if the fin is made up of alternating layers of Si and SiGe (as may be used for a GAA structure) both types of layers will be removed together. The size of the cavity is defined by the initial fin width and by the multi-layer spacer structure. According to some embodiments, the first dielectric layer is exposed to the inner region of the cavity while the third dielectric layer is exposed along the outside sidewall of the sacrificial gate.

Method 1400 continues with operation 1416 where the first dielectric layer along the side of the cavity and the third dielectric layer along the side of the sacrificial gate are simultaneously removed. An isotropic wet etching process may be used to simultaneously remove the exposed first dielectric layer from along the side of the cavity and the exposed third dielectric layer from along the side of the sacrificial gate. The simultaneous removal can be made possible if the first dielectric layer and the third dielectric layer are the same material. Additionally, the isotropic etching of the first dielectric layer and the third dielectric layer is selective and does not substantially etch the second dielectric layer, according to some embodiments. Using a single process step to simultaneously trim the spacer width along the gate while also increasing the cavity width to provide a wider source or drain region streamlines the fabrication process and provides greater control over various device critical dimensions.

### Example System

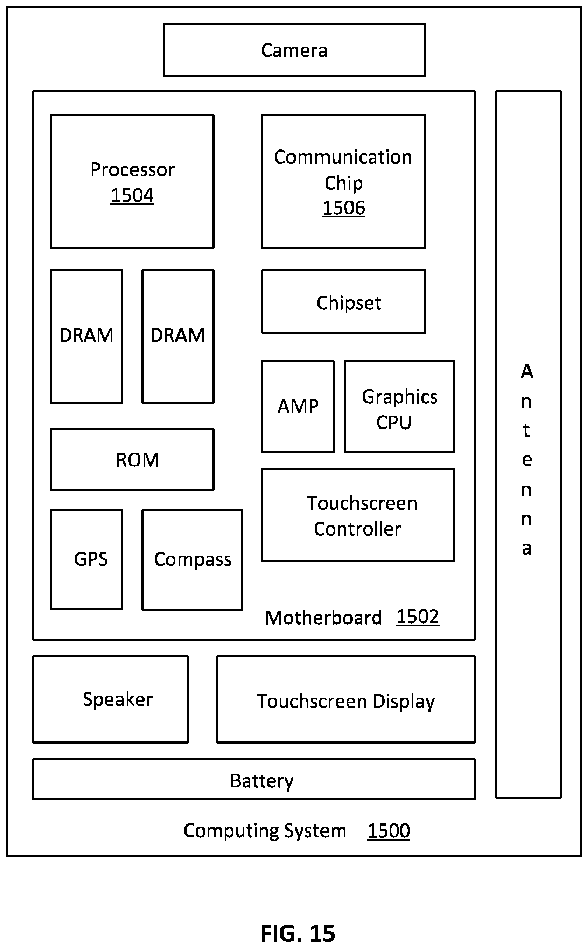

FIG. 15 is an example computing system implemented with one or more of the integrated circuit structures as disclosed herein, in accordance with some embodiments of the present disclosure. As can be seen, the computing system 1500 houses a motherboard 1502. The motherboard 1502 may include a number of components, including, but not limited to, a processor 1504 and at least one communication chip 1506, each of which can be physically and electrically coupled to the motherboard 1502, or otherwise integrated therein. As will be appreciated, the motherboard 1502 may be, for example, any printed circuit board (PCB), whether a main board, a daughterboard mounted on a main board, or the only board of system 1500, etc.

Depending on its applications, computing system 1500 may include one or more other components that may or may not be physically and electrically coupled to the motherboard 1502. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1500 may include one or more integrated circuit structures or devices configured in accordance with an example embodiment (e.g., a module including an integrated circuit device on a substrate, the substrate having one or more semiconductor devices with multi-layered spacer structures, as variously provided herein). In some embodiments, multiple functions can be integrated into one or more chips (e.g., for instance, note that the communication chip 1506 can be part of or otherwise integrated into the processor 1504).

The communication chip 1506 enables wireless communications for the transfer of data to and from the computing system 1500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1506 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1500 may include a plurality of communication chips 1506. For instance, a first communication chip 1506 may be dedicated to shorter range wireless communications such as Wi-Fi and Bluetooth and a second communication chip 1506 may be dedicated to longer range wireless communications such as GPS, EDGE, GPRS, CDMA, WiMAX, LTE, Ev-DO, and others.

The processor 1504 of the computing system 1500 includes an integrated circuit die packaged within the processor 1504. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1506 also may include an integrated circuit die packaged within the communication chip 1506. In accordance with some such example embodiments, the integrated circuit die of the communication chip includes one or more semiconductor devices as variously described herein. As will be appreciated in light of this disclosure, note that multi-standard wireless capability may be integrated directly into the processor 1504 (e.g., where functionality of any chips 1506 is integrated into processor 1504, rather than having separate communication chips). Further note that processor 1504 may be a chip set having such wireless capability. In short, any number of processor 1504 and/or communication chips 1506 can be used. Likewise, any one chip or chip set can have multiple functions integrated therein.

In various implementations, the computing system 1500 may be a laptop, a netbook, a notebook, a smartphone, a tablet, a personal digital assistant (PDA), an ultramobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1500 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.
Example 1 is an integrated circuit that includes a semiconductor device having a semiconductor material extending between a source region and a drain region, a gate layer extending over the semiconductor material, and a spacer structure that includes a first spacer portion adjacent to the gate layer, a second spacer portion adjacent to the source region or the drain region, and a third spacer portion between the first and second spacer portions. The first spacer portion includes a first layer of first dielectric material along a sidewall of the gate layer. The second spacer portion includes a second layer of second dielectric material along a sidewall of the source region or drain region. The third spacer portion includes the first layer of first dielectric material, the second layer of second dielectric material, and a third layer of third dielectric material compositionally different than the first and second dielectric materials.
Example 2 includes the subject matter of Example 1, wherein the semiconductor material comprises one or more nanoribbons.
Example 3 includes the subject matter of Example 2, wherein the one or more nanoribbons comprise germanium, silicon, or silicon and germanium.
Example 4 includes the subject matter of any one of Examples 1-3, wherein the first and second dielectric materials are the same dielectric material.
Example 5 includes the subject matter of Example 4, wherein the first and second dielectric materials comprise silicon, oxygen, and carbon, and the third dielectric material comprises silicon and oxygen.
Example 6 includes the subject matter of any one of Examples 1-5, wherein the third layer has a thickness that is less than the first and second layers.
Example 7 includes the subject matter of any one of Examples 1-6, wherein the semiconductor device is on a substrate, and the integrated circuit further comprises a conductive layer within the substrate and adjacent to the semiconductor device, or below the substrate and semiconductor device,
Example 8 includes the subject matter of any one of Examples 1-7, wherein the first spacer portion does not include the third layer, and the second spacer portion does not include the third layer.
Example 9 includes the subject matter of any one of Examples 1-8, wherein the third layer is sandwiched between the first layer and the second layer in the third spacer portion.
Example 10 is a printed circuit board comprising the integrated circuit of any one of Examples 1-9.
Example 11 is an electronic device that includes a chip package having one or more dies. At least one of the one or more dies includes a semiconductor device comprising a semiconductor region extending between a source region and a drain region, a gate layer extending over the semiconductor region, and a spacer structure comprising a first spacer portion adjacent to the gate layer, a second spacer portion adjacent to the source region or the drain region, and a third spacer portion between the first and second spacer portions. A first layer of first dielectric material extends along a sidewall of the gate layer in the first spacer portion and the first layer extends into the third spacer portion. A second layer of second dielectric material extends along a sidewall of the source region or drain region in the second spacer portion and the second layer extends into the third spacer portion. A third layer of third dielectric material compositionally different than the first and second dielectric materials extends within the third spacer portion along with the first and second layers.
Example 12 includes the subject matter of Example 11, wherein the semiconductor region comprises one or more nanoribbons.
Example 13 includes the subject matter of Example 12, wherein the one or more nanoribbons comprise germanium, silicon, or germanium and silicon.
Example 14 includes the subject matter of any one of Examples 11-13, wherein the first and second dielectric materials are the same dielectric material.
Example 15 includes the subject matter of Example 14, wherein the first and second dielectric materials comprise silicon, oxygen, and carbon, and the third dielectric material comprises silicon and oxygen.
Example 16 includes the subject matter of any one of Examples 11-15, wherein the third layer has a thickness that is less than the first and second layers.
Example 17 includes the subject matter of any one of Examples 11-16, wherein the semiconductor device is on a substrate, and the at least one of the one or more dies further comprises a buried conductive layer within the substrate and adjacent to the semiconductor device.
Example 18 includes the subject matter of any one of Examples 11-17, wherein the first spacer portion does not include the third layer and the second spacer portion does not include the third layer.
Example 19 includes the subject matter of any one of Examples 11-18, wherein the third layer is sandwiched between the first layer and the second layer in the third spacer portion.
Example 20 includes the subject matter of any one of Examples 11-19, further comprising a printed circuit board, wherein the chip package is attached to the printed circuit board.
Example 21 is a method of forming an integrated circuit. The method includes forming a fin comprising semiconductor material on a substrate; forming a sacrificial gate over a portion of the fin, such that a first portion of the fin is beneath the sacrificial gate and a second portion of the fin is adjacent to the sacrificial gate; forming a first layer of a spacer structure along a sidewall of the sacrificial gate and along a sidewall of the second portion of the fin, the first layer comprising a first dielectric material; forming a second layer of the spacer structure on the first layer along the sidewall of the sacrificial gate and on the first layer along the sidewall of the second portion of the fin, the second layer comprising a second dielectric material; forming a third layer of the spacer structure on the second layer along the sidewall of the sacrificial gate and on the second layer along the sidewall of the second portion of the fin, the third layer comprising a third dielectric material; removing the spacer structure from a top surface of the second portion of the fin; removing the second portion of the fin leaving behind a cavity; and simultaneously removing the first layer of the spacer structure adjacent to the cavity and the third layer of the spacer structure along the sidewall of the sacrificial gate.
Example 22 includes the subject matter of Example 21, wherein forming the fin comprises recessing a dielectric layer adjacent to the fin such that the fin extends above a top surface of the dielectric layer.
Example 23 includes the subject matter of Example 21 or 22, wherein the first dielectric material and the third dielectric material are the same dielectric material.
Example 24 includes the subject matter of Example 23, wherein the second dielectric material is compositionally different from the first and third dielectric materials.
Example 25 includes the subject matter of any one of Examples 21-24, further comprising forming a buried conductive layer within the substrate and adjacent to the fin.
Example 26 includes the subject matter of any one of Examples 21-25, further comprising simultaneously removing the second layer of the spacer structure adjacent to the cavity and along the sidewall of the sacrificial gate.
Example 27 includes the subject matter of Example 26, further comprising forming a source or drain region within the cavity following the removal of the second layer.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a semiconductor device comprising a semiconductor material extending between a source region and a drain region;
a gate layer extending over the semiconductor material; and
a spacer structure comprising a first spacer portion adjacent to the gate layer, a second spacer portion adjacent to the source region or the drain region, and a third spacer portion between the first and second spacer portions, wherein the first spacer portion includes a first layer of first dielectric material along a sidewall of the gate layer, the second spacer portion includes a second layer of second dielectric material along a sidewall of the source region or drain region, and the third spacer portion includes the first layer of first dielectric material, the second layer of second dielectric material, and a third layer of third dielectric material compositionally different than the first and second dielectric materials.

2. The integrated circuit of claim 1, wherein the semiconductor material comprises one or more nanoribbons.

3. The integrated circuit of claim 2, wherein the one or more nanoribbons comprise germanium, silicon, or silicon and germanium.

4. The integrated circuit of any one of claims 1 through 3, wherein the first and second dielectric materials are the same dielectric material.

5. The integrated circuit of claim 4, wherein the first and second dielectric materials comprise silicon, oxygen, and carbon, and the third dielectric material comprises silicon and oxygen.

6. The integrated circuit of any one of claims 1 through 5, wherein the third layer has a thickness that is less than the first and second layers.

7. The integrated circuit of any one of claims 1 through 6, wherein the semiconductor device is on a substrate, and the integrated circuit further comprises a conductive layer within the substrate and adjacent to the semiconductor device, or below the substrate and semiconductor device.

8. The integrated circuit of any one of claims 1 through 7, wherein the first spacer portion does not include the third layer, and the second spacer portion does not include the third layer.

9. The integrated circuit of any one of claims 1 through 8, wherein the third layer is sandwiched between the first layer and the second layer in the third spacer portion.

10. A printed circuit board comprising the integrated circuit of any one of claims 1 through 9.

11. A method of forming an integrated circuit, the method comprising:
forming a fin comprising semiconductor material on a substrate;
forming a sacrificial gate over a portion of the fin, such that a first portion of the fin is beneath the sacrificial gate and a second portion of the fin is adjacent to the sacrificial gate;
forming a first layer of a spacer structure along a sidewall of the sacrificial gate and along a sidewall of the second portion of the fin, the first layer comprising a first dielectric material;
forming a second layer of the spacer structure on the first layer along the sidewall of the sacrificial gate and on the first layer along the sidewall of the second portion of the fin, the second layer comprising a second dielectric material;
forming a third layer of the spacer structure on the second layer along the sidewall of the sacrificial gate and on the second layer along the sidewall of the second portion of the fin, the third layer comprising a third dielectric material;
removing the spacer structure from a top surface of the second portion of the fin;
removing the second portion of the fin leaving behind a cavity; and
simultaneously removing the first layer of the spacer structure adjacent to the cavity and the third layer of the spacer structure along the sidewall of the sacrificial gate.

12. The method of claim 11, wherein forming the fin comprises recessing a dielectric layer adjacent to the fin such that the fin extends above a top surface of the dielectric layer.

13. The method of claim 11 or 12, wherein the first dielectric material and the third dielectric material are the same dielectric material, and the second dielectric material is compositionally different from the first and third dielectric materials.

14. The method of any one of claims 11 through 13, further comprising forming a buried conductive layer within the substrate and adjacent to the fin.

15. The method of any one of claims 11 through 14, further comprising simultaneously removing the second layer of the spacer structure adjacent to the cavity and along the sidewall of the sacrificial gate.
